# EUROPÄISCHE PATENTANMELDUNG

(11) **EP 4 095 894 A1**
(43) Veröffentlichungstag der Anmeldung: **30.11.2022**
(21) Anmeldenummer: 21175897.4
(22) Anmeldetag: 26.05.2021
(51) Int. Cl.: H01L 23/29, H01L 23/31, H01L 23/16, H01L 21/56

(54) **MIT EINER UMHÜLLUNG AUS EINER HYDRAULISCH GEHÄRTETEN ANORGANISCHEN ZEMENTZUSAMMENSETZUNG VERSEHENES ELEKTRONIKOBJEKT**

(71) Anmelder: Heraeus Deutschland GmbH & Co. KG, 63450 Hanau (DE)
(72) Erfinder: SCHEIBEL, Markus, 63450 Hanau (DE); ALBERT, Tamara, 63450 Hanau (DE); MIRIC, Anton-Zoran, 63450 Hanau (DE); PELSHAW, Nadja, 63450 Hanau (DE); ROTH, Frederik, 63450 Hanau (DE); EISELE, Roland, 24149 Kiel (DE)
(74) Vertreter: Heraeus IP

(57) **Zusammenfassung**

Elektronikobjekt mit einer mindestens eine wesentliche äußere Sichtfläche aufweisenden Umhüllung aus einer hydraulisch gehärteten anorganischen Zementzusammensetzung, wobei die jeweilige wesentliche äußere Sichtfläche der Umhüllung an ihrer Oberfläche und/oder innerhalb ihres unmittelbaren Untergrundes unterteilt ist.

## Beschreibung

Die Erfindung betrifft ein Elektronikobjekt mit einer Umhüllung aus einer hydraulisch gehärteten anorganischen Zementzusammensetzung, wobei mindestens eine wesentliche äußere Sichtfläche der Umhüllung an ihrer Oberfläche und/oder innerhalb ihres unmittelbaren Untergrundes unterteilt ist. Die Erfindung betrifft auch Verfahren zur Herstellung derartiger umhüllter Elektronikobjekte.

Elektronikobjekte im Sinne der vorliegenden Erfindung umfassen beispielsweise Spulen und insbesondere elektronische Baugruppen.

Hierin wird der Begriff "elektronische Baugruppe" verwendet. Eine elektronische Baugruppe im Sinne der vorliegenden Erfindung umfasst mindestens ein Substrat und mindestens ein damit mechanisch und elektrisch verbundenes elektronisches Bauteil. Die mechanische und elektrische Verbindung kann eine elektrisch leitfähige Lot-, Sinter- und/oder Klebeverbindung sein. Ferner kann eine solche elektronische Baugruppe einer elektrischen Verbindung dienende Elemente wie Bondbändchen, Bonddrähte, Clips, Abstandshalter und/oder Folien umfassen. Beispiele für elektronische Baugruppen in Rahmen- oder rahmenloser Bauweise umfassen diskrete Bauteile wie sogenannte power discretes, Leistungsmodule, Spannungswandler und bestimmte Sensoren.

Beispiele für Substrate umfassen IMS-Substrate (insulated metal-Substrate, isolierte Metallsubstrate), AMB-Substrate (active metal brazed-Substrate), DCB-Substrate (direct copper bonded-Substrate), Keramiksubstrate, PCBs (printed circuit boards, gedruckte Leiterplatten) und Leadframes.

Elektronische Bauteile können eingeteilt werden in aktive und passive elektronische Bauteile.

Beispiele für aktive elektronische Bauteile umfassen Dioden, LEDs (light emitting diodes, Leuchtdioden), Dies (Halbleiterchips), IGBTs (insulated-gate bipolar transistors, Bipolartransistoren mit isolierter Gate-Elektrode), ICs (integrated circuits, integrierte Schaltungen) und MOSFETs (metal-oxide-semiconductor field-effect transistors, Metall-Oxid-Halbleiter-Feldeffekttransistoren).

Beispiele für passive elektronische Bauteile umfassen Bodenplatten, Kühlkörper, Verbindungselemente, Widerstände, Kondensatoren, Induktoren, Antennen und keine elektronischen Baugruppen darstellende Sensoren.

Die Umhüllung aus der hydraulisch gehärteten anorganischen Zementzusammensetzung kann ein betreffendes Elektronikobjekt mit Ausnahme von notwendigen nach außen führenden elektrischen Kontaktierungen sowie von eventuell vorhandenen wärmeableitfähigen Anbindungen (z.B. metallische Bodenplatten) vollständig oder im Allgemeinen teilweise umhüllen und nimmt mehrere Aufgaben wahr. Insbesondere dient sie der elektrischen Isolierung und dem Schutz des Elektronikobjektes vor äußeren Einflüssen, beispielsweise Schutz vor eindringender Feuchtigkeit. Ferner kann die Umhüllung aus der hydraulisch gehärteten anorganischen Zementzusammensetzung Wärme aus einem mit ihr umhüllten Elektronikobjekt abführen, beispielsweise aus einer mit ihr umhüllten aktive elektronische Bauteile umfassenden elektronischen Baugruppe während deren Betrieb.

WO2015/193035A1 offenbart elektronische Baugruppen mit einer Umhüllung aus einer hydraulisch gehärteten anorganischen Zementzusammensetzung.

Unter der mindestens einen wesentlichen äußeren Sichtfläche der von einer hydraulisch gehärteten anorganischen Zementzusammensetzung gebildeten Umhüllung eines Elektronikobjektes ist die jeweils größte bzw. sind die jeweils größten all ihrer Sichtflächen zu verstehen. Nicht von einer hydraulisch gehärteten anorganischen Zementzusammensetzung gebildete Sichtflächen eines solchen umhüllten Elektronikobjektes können beispielsweise von dem Elektronikobjekt selber gebildet werden; in diesem Falle handelt es sich um ein mit einer hydraulisch gehärteten anorganischen Zementzusammensetzung teilweise umhülltes Elektronikobjekt.

Der hierin verwendete Begriff "Sichtfläche" bedeutet eine einem Betrachter zugängliche nach außen weisende Fläche, insbesondere nach außen weisende ebene Fläche. Am Beispiel eines Würfels erläutert bedeutet dies, dass ein Würfel sechs quadratische Sichtflächen gleichen Formats hat, während die sechs rechteckigen Sichtflächen eines Quaders sich entweder in vier gleich große Sichtflächen vom Format A und zwei gleich große Sichtflächen vom Format B ≠ A oder in zwei gleich große Sichtflächen vom Format A', zwei gleich große Sichtflächen vom Format B' und zwei gleich große Sichtflächen vom Format C' aufteilen, wobei gilt A' ≠ B' ≠ C'.

Bei elektronischen Baugruppen mit einer Umhüllung aus einer hydraulisch gehärteten anorganischen Zementzusammensetzung handelt es sich um flache Gebilde mit zwei einander parallel gegenüberliegenden vergleichsweise großen äußeren Oberflächen und einem schmalen umlaufenden Rand. Beispielsweise besteht der schmale umlaufende Rand im Falle einer quadratischen Ausführungsform aus vier gleich langen Abschnitten. Das Flächenmaß der beiden vergleichsweise großen äußeren Oberflächen kann üblicherweise im Bereich von jeweils beispielsweise 10 bis 200 cm² liegen. So können beispielsweise rechteckige umhüllte elektronische Baugruppen äußere Oberflächen im Format von beispielsweise jeweils 2 cm x 5 cm bis 13 cm x 15 cm aufweisen. Eine der beiden äußeren Oberflächen wird dabei durch die hydraulisch gehärtete anorganische Zementzusammensetzung gebildet; bei dieser äußeren Oberfläche handelt es sich im Sinne der Erfindung um die - im vorliegenden Falle einzige - wesentliche äußere Sichtfläche der Umhüllung. Die andere der beiden einander gegenüberliegenden äußeren Oberflächen wird im Allgemeinen von der Unterseite der elektronischen Baugruppe des Elektronikobjektes, beispielsweise der Substratunterseite oder einer darunter befestigten metallischen Bodenplatte, einem zugleich als Bodenplatte ausgebildeten Kühlkörper oder einer metallischen Bodenplatte und einem Kühlkörper gebildet. Die mit einer hydraulisch gehärteten anorganischen Zementzusammensetzung umhüllten elektronischen Baugruppen können rahmenlos sein oder einen Rahmen beispielsweise aus Kunststoff oder Kunstharz aufweisen. Im letzteren Falle ist der schmale umlaufende Rand vom Rahmen umschlossen, während die wesentliche äußere Sichtfläche der Umhüllung einem Betrachter im Allgemeinen unmittelbar oder aber nach Entfernung eines optionalen und die unmittelbare Sicht verhindernden Elements, beispielsweise eines optionalen abnehmbaren Deckels, zugänglich ist.

Der hierin verwendete Begriff "hydraulisches Härten" bedeutet Abbinden in Gegenwart von Wasser respektive nach Zusatz von Wasser.

Hierin wird unterschieden zwischen hydraulisch härtbarem anorganischem Zement, wässriger hydraulisch härtbarer anorganischer Zementzubereitung und hydraulisch gehärteter anorganischer Zementzusammensetzung. Aus hydraulisch härtbarem anorganischem Zement, welcher in Pulverform vorliegt, kann durch Vermischen mit Wasser eine wässrige hydraulisch härtbare anorganische Zementzubereitung insbesondere in Form einer viskoelastischen, beispielsweise pastösen oder fließfähigen Masse hergestellt werden, auch als "Zementleim (englisch: cement paste oder cement glue)" bezeichnet. Eine wässrige hydraulisch härtbare anorganische Zementzubereitung wiederum kann hydraulisch zu einer hydraulisch gehärteten anorganischen Zementzusammensetzung in Form eines harten Festkörpers aushärten, auch als "Zementstein (englisch: cement stone)" bezeichnet. Eine derartige hydraulisch gehärtete anorganische Zementzusammensetzung ist praktisch wasserunlöslich, d.h. im Wesentlichen oder vollständig wasserunlöslich.

Es wurde festgestellt, dass beim Umhüllen eines Elektronikobjektes mit einer wässrigen hydraulisch härtbaren anorganischen Zementzubereitung Probleme mit unerwünschter ungleichmäßig tiefer bis hin zum eigentlichen innenliegenden Elektronikobjekt reichender Rissbildung während der hydraulischen Härtung und Trocknung auftreten können, insbesondere innerhalb der mindestens einen wesentlichen äußeren Sichtfläche der Umhüllung. Diese Problematik verstärkt sich mit zunehmender Größe bzw. Oberfläche der Umhüllung. Es wird angenommen, dass die unerwünschte, ungleichmäßig tiefe und örtlich zufällige Rissbildung schrumpfbedingt ist oder getrieben ist aus einer thermomechanischen Verwölbung während der hydraulischen Härtung und Trocknung. Solche unregelmäßigen Risse in der mindestens einen wesentlichen äußeren Sichtfläche der Umhüllung sind nicht nur optisch störend, sondern sie stellen insbesondere in die Tiefe führende Eintrittspforten für Feuchtigkeit und andere Umwelteinflüsse dar, welche das innenliegende Elektronikobjekt schädigen können. Bisher konnte man derartige Probleme lösen mit einem zusätzlichen Verguss mit Kunststoff- oder Kunstharzmassen beispielsweise in Gestalt von Silikon-Gel.

Es wurde gefunden, dass die beschriebene Problematik überraschenderweise auch ohne einen zusätzlichen Verguss mit Kunststoff- oder Kunstharzmassen überwunden werden kann, wenn eine Umhüllung vom vorerwähnten Typ aus einer hydraulisch gehärteten anorganischen Zementzusammensetzung eine Unterteilung aufweist.

Gegenstand der Erfindung ist daher ein Elektronikobjekt, insbesondere eine elektronische Baugruppe, mit einer mindestens eine wesentliche äußere Sichtfläche aufweisenden Umhüllung aus einer hydraulisch gehärteten anorganischen Zementzusammensetzung, wobei die jeweilige wesentliche äußere Sichtfläche der Umhüllung an ihrer Oberfläche und/oder innerhalb ihres unmittelbaren Untergrundes unterteilt ist.

Hierin wird mehrfach der Begriff des "unmittelbaren Untergrundes" mit Bezugnahme auf eine jeweilige wesentliche äußere Sichtfläche der Umhüllung verwendet. Damit ist der unmittelbar unter der Oberfläche der Umhüllung befindliche Bereich beispielsweise bis zu einer Tiefe von ≤ 8 mm, bevorzugt der Bereich von 0,1 bis 8 mm, insbesondere der Bereich von 0,1 bis 2 mm gemeint.

Um Missverständnisse auszuschließen, selbstverständlich werden sowohl Oberfläche als auch der gesamte Untergrund, d.h. der unmittelbare Untergrund sowie der darunter befindliche weitere Untergrund, aus derselben hydraulisch gehärteten anorganischen Zementzusammensetzung gebildet. Besagte und nachstehend näher erläuterte Unterteilung ist in jedem Falle so verwirklicht, dass die Schichtdicke der kontinuierlichen und unterhalb der Unterteilung befindlichen hydraulisch gehärteten anorganischen Zementzusammensetzung hinreichend stark, beispielsweise im Bereich von 0,3 bis 4 cm dick ist.

Die Unterteilung einer wesentlichen äußeren Sichtfläche der Umhüllung kann auf verschiedene Art realisiert sein. Ausführungsformen des Erfindungsgegenstands können daher ein Elektronikobjekt mit einer Umhüllung aus einer hydraulisch gehärteten anorganischen Zementzusammensetzung betreffen, wobei die mindestens eine wesentliche äußere Sichtfläche der Umhüllung (i) visuell erkennbar in mindestens zwei Teilflächen unterteilt und/oder (ii) innerhalb ihres unmittelbaren Untergrundes in mindestens zwei Teilflächen unterteilt ist. Wie nachstehend noch erläutert, sind Kombinationen der Ausführungsformen (i) und (ii) möglich, wenngleich nicht unbedingt bevorzugt.

In der Ausführungsform (i) ist die jeweilige wesentliche äußere Sichtfläche der Umhüllung visuell erkennbar in mindestens zwei Teilflächen unterteilt; dabei kann die Unterteilung in einer Variante (i1) als geringe Vertiefung, beispielsweise als ≤ 5 mm, bevorzugt im Bereich von 0,2 bis 5 mm, insbesondere im Bereich von 0,2 bis 2 mm tiefe Vertiefung, beispielsweise Einkerbung, verwirklicht und visuell erkennbar sein. Die Unterteilung kann aber auch in einer Variante (i2) dergestalt verwirklicht sein, dass mindestens ein Unterteilungselement (die Unterteilung bewirkendes Element; zur Unterteilung der jeweiligen wesentlichen äußeren Sichtfläche der Umhüllung in mindestens zwei Teilflächen befähigtes Element) visuell erkennbar vorhanden ist; bei dieser Variante (i2) dringt das mindestens eine Unterteilungselement in die jeweilige wesentliche äußere Sichtfläche der Umhüllung mit einer geringen Eindringtiefe von beispielsweise ≤ 5 mm, bevorzugt im Bereich von 0,2 bis 5 mm, insbesondere im Bereich von 0,2 bis 2 mm ein. Auch Kombinationen der Varianten (i1) und (i2) sind möglich, wenngleich nicht unbedingt bevorzugt.

In der Ausführungsform (ii) ist die jeweilige wesentliche äußere Sichtfläche der Umhüllung innerhalb ihres unmittelbaren Untergrundes, d.h. beispielsweise in einer geringen Tiefe von ≤ 8 mm, bevorzugt im Bereich von 0,1 bis 8 mm, insbesondere im Bereich von 0,1 bis 2 mm in mindestens zwei Teilflächen unterteilt. Hier befindet sich mindestens ein Unterteilungselement für einen Betrachter nicht sichtbar innerhalb des unmittelbaren Untergrundes der jeweiligen wesentlichen äußeren Sichtfläche der Umhüllung, also mitumhüllt, beispielsweise ähnlich einer Armierung. An den Bereich des unmittelbaren Untergrundes schließt sich unterhalb davon der vorerwähnte beispielsweise 0,3 bis 4 cm dicke Bereich der kontinuierlichen und unterteilungsfreien hydraulisch gehärteten anorganischen Zementzusammensetzung an.

Die Verwirklichung einer Kombination der Ausführungsformen (i) und (ii) bedeutet die Anwesenheit (Vorhandensein) mindestens eines Unterteilungselements innerhalb des unmittelbaren Untergrundes einer jeweiligen wesentlichen äußeren Sichtfläche der Umhüllung, beispielsweise entsprechend der Kombination der Ausführungsformen (i1) und (ii); gegebenenfalls kann zusätzlich ein in die jeweilige wesentliche äußere Sichtfläche der Umhüllung mit besagter geringer Eindringtiefe eindringendes weiteres Unterteilungselement anwesend sein, in dem Fall entsprechend der Kombination der Ausführungsformen (i2) und (ii). Aber auch bei Anwesenheit nur eines Unterteilungselements können beide Ausführungsformen (i2) und (ii) zugleich im Sinne einer Kombination verwirklicht sein, beispielsweise indem sich das eine einzige Unterteilungselement nur teilflächig innerhalb des unmittelbaren Untergrundes der jeweiligen wesentlichen äußeren Sichtfläche der Umhüllung befindet, während es mit seiner verbleibenden Teilfläche lediglich mit besagter geringer Eindringtiefe in die jeweilige wesentliche äußere Sichtfläche der Umhüllung eindringt.

Beispielhaft sind in nachfolgender tabellarischer Zusammenstellung verschiedene Verwirklichungsmöglichkeiten der Ausführungsformen (i) und (ii) respektive Kombinationen davon schematisch und stichwortartig dargestellt:

| | | |
|---|---|---|
| **Verwirklichung 1** | wesentliche Sichtfläche unterteilt gemäß (i1) | |
| | Unmittelbarer Untergrund ohne Unterteilung | |
| | | |
| **Verwirklichung 2** | wesentliche Sichtfläche unterteilt gemäß (i2) | |
| | Unmittelbarer Untergrund ohne Unterteilung | |
| | | |
| **Verwirklichung 3** | wesentliche Sichtfläche ohne Unterteilung | |
| | Unmittelbarer Untergrund unterteilt gemäß (ii) | |
| | | |
| **Verwirklichung 4** | wesentliche Sichtfläche unterteilt gemäß (i1) | |
| | Unmittelbarer Untergrund unterteilt gemäß (ii) | |
| **Verwirklichung 5** | wesentliche Sichtfläche unterteilt gemäß (i2) | |
| | Unmittelbarer Untergrund unterteilt gemäß (ii) | |
| | | |
| **Verwirklichung 6** | Anteil von wesentlicher Sichtfläche unterteilt gemäß (i1) | Anteil von wesentlicher Sichtfläche ohne Unterteilung |
| | Unmittelbarer Untergrund unterteilt gemäß (ii) | |
| | | |
| **Verwirklichung 7** | Anteil von wesentlicher Sichtfläche unterteilt gemäß (i2) | Anteil von wesentlicher Sichtfläche ohne Unterteilung |
| | Unmittelbarer Untergrund unterteilt gemäß (ii) | |
| | | |
| **Verwirklichung 8** | Anteil von wesentlicher Sichtfläche unterteilt gemäß (i1) | Anteil von wesentlicher Sichtfläche unterteilt gemäß (i2) |
| | Unmittelbarer Untergrund ohne Unterteilung | |
| | | |
| **Verwirklichung 9** | Anteil von wesentlicher Sichtfläche unterteilt gemäß (i1) | Anteil von wesentlicher Sichtfläche unterteilt gemäß (i2) |
| | Unmittelbarer Untergrund unterteilt gemäß (ii) | |
| | | |
| **Verwirklichung 10** | Anteil von wesentlicher Sichtfläche unterteilt gemäß (i1) | Anteil von wesentlicher Sichtfläche ohne Unterteilung |
| | Unmittelbarer Untergrund anteilig ohne Unterteilung | Unmittelbarer Untergrund anteilig unterteilt gemäß (ii) |
| | | |
| **Verwirklichung 11** | Anteil von wesentlicher Sichtfläche unterteilt gemäß (i2) | Anteil von wesentlicher Sichtfläche ohne Unterteilung |
| | Unmittelbarer Untergrund anteilig ohne Unterteilung | Unmittelbarer Untergrund anteilig unterteilt gemäß (ii) |

Ein Unterteilungselement im Sinne der vorliegenden Erfindung kann von einem nachstehend noch erläuterten temporären oder nichttemporären Rahmen mitumfasst oder als solcher ausgebildet sein.

Bei einem Unterteilungselement im Sinne der vorliegenden Erfindung kann es sich insbesondere um ein Öffnungen aufweisendes Flächengebilde handeln. Bei Öffnungen aufweisenden Flächengebilden im Sinne der vorliegenden Erfindung kann es sich beispielsweise um Gitter, Lochplatten, Siebe, Gewebe oder Netze handeln. Die Öffnungen sind beispielsweise im Bereich von 7850 µm² bis 4 cm² groß, so kann der Durchmesser beispielsweise runder Öffnungen oder die Kantenlänge beispielsweise quadratischer oder rechteckiger Öffnungen beispielsweise im Bereich von 100 µm bis 2 cm liegen. Ein Öffnungen aufweisendes Flächengebilde im Sinne der vorliegenden Erfindung kann in Form und Größe der jeweiligen wesentlichen äußeren Sichtfläche der Umhüllung zweckmäßig angepasst sein oder entsprechen, beispielsweise 50 bis 100 % dessen Formats entsprechen, es ist jedoch im Allgemeinen nicht größer als die jeweilige wesentliche äußere Sichtfläche der Umhüllung.

Ein Öffnungen aufweisendes Flächengebilde im Sinne der vorliegenden Erfindung kann aus einem oder mehreren verschiedenen und zweckmäßigerweise elektrisch nicht leitfähigen Materialien bestehen. Beispiele für geeignete Materialien umfassen Kunststoffe (gegebenenfalls faserverstärkt), Textilfaser, Baumwolle, Glasfaser und Steinwolle. Im Fall der vorerwähnten Ausführungsformen (i2) und (ii) kann es zweckmäßig sein, wenn das Öffnungen aufweisende Flächengebilde vorbeschichtet ist beispielsweise mit hydraulisch härtbarem und bevorzugt anorganischem Material wie beispielsweise Gips oder hydraulisch härtbarem anorganischem Zement. Um Missverständnisse auszuschließen, die Anordnung eines Unterteilungselements, insbesondere in Gestalt eines Öffnungen aufweisenden Flächengebildes, ist flächenparallel zur jeweiligen wesentlichen äußeren Sichtfläche der Umhüllung, im Speziellen flächenparallel zur Ebene einer jeweiligen ebenen wesentlichen äußeren Sichtfläche der Umhüllung.

Die hydraulisch gehärtete anorganische Zementzusammensetzung kann aus einem hydraulisch gehärteten anorganischen Zement bestehen oder neben dem hydraulisch gehärteten anorganischen Zement, d.h. neben dem eine Matrix bildenden hydraulisch gehärteten anorganischen Zement, einen oder mehrere weitere Bestandteile umfassen, beispielsweise in einem Gesamtmengenanteil von 0,5 bis 98 Gew.-%. In beiden Fällen kann die hydraulisch gehärtete anorganische Zementzusammensetzung insbesondere gebildet werden durch Vermischen von hydraulisch härtbarem anorganischem Zement plus gegebenenfalls dem mindestens einen weiteren Bestandteil mit Wasser zu einer wässrigen hydraulisch härtbaren anorganischen Zementzubereitung, Applikation derselben, gefolgt von deren hydraulischer Härtung und Trocknung.

Die wässrige hydraulisch härtbare anorganische Zementzubereitung kann einen Wasseranteil von beispielsweise 6 bis 25 Gew.-% aufweisen.

Die Viskosität einer frisch hergestellten (innerhalb von 5 Minuten nach Fertigstellung) wässrigen hydraulisch härtbaren anorganischen Zementzubereitung kann beispielsweise im Bereich von 0,5 bis 20 Pa·s (bei Bestimmung mittels Rotationsviskosimetrie, Platte-Platte-Messprinzip, Plattendurchmesser 25 mm, Messspalt 1 mm, Probentemperatur 20°C) liegen.

Umfasst die hydraulisch gehärtete anorganische Zementzusammensetzung neben dem hydraulisch gehärteten anorganischen Zement einen oder mehrere weitere Bestandteile, so umfasst auch die wässrige hydraulisch härtbare anorganische Zementzubereitung neben dem hydraulisch härtbaren anorganischen Zement und Wasser einen oder mehrere weitere Bestandteile, insbesondere den oder die gleichen Bestandteile. Solche weiteren Bestandteile können schon dem hydraulisch härtbaren anorganischen Zement beigegeben respektive zugemischt werden. Es ist auch möglich, zunächst den hydraulisch härtbaren anorganischen Zement mit allen der weiteren Bestandteile ohne Wasserzusatz und danach mit Wasser zur wässrigen hydraulisch härtbaren anorganischem Zementzubereitung zu vermischen. Es kann aber auch so gearbeitet werden, dass der oder die weiteren Bestandteile separat vor, während und/oder nach dem Wasserzusatz zugegeben werden. Mengenanteil, Zugabezeitpunkt bzw. Zugabereihenfolge richten sich nach den betreffenden chemischen und physikalischen Eigenschaften während der Herstellung der wässrigen hydraulisch härtbaren anorganischen Zementzubereitung im Hinblick auf deren Homogenität und Handhabbarkeit; aus praktischer Sicht wird sich der Fachmann hier insbesondere am Mischverhalten und am Verarbeitungsverhalten, beispielsweise der sogenannten Topfzeit (englisch: pot life) orientieren.

Der oder die vorerwähnten weiteren Bestandteile können in einem Gesamtmengenanteil von beispielsweise 0,1 bis 92 Gew.-%, bezogen auf die wässrige hydraulisch härtbare anorganische Zementzubereitung, umfasst sein.

Der hydraulisch härtbare anorganische Zement als solcher ist ein schüttfähiges Pulver. Es kann sich beispielsweise um einen dem Fachmann bekannten Portlandzement, Tonerdezement, Magnesiumoxidzement, Phosphatzement, beispielsweise Zinkphosphatzement oder bevorzugt Magnesiumphosphatzement handeln.

Beispiele für vorerwähnte weitere Bestandteile umfassen Füllstoffe, Fasern, Fließverbesserer, Abbindeverzögerer (Topfzeitverlängerer), Entschäumer, wassermischbare organische Lösemittel, Hydrophobisierungsmittel, Oberflächenspannung beeinflussende Additive, Benetzungsmittel und Haftvermittler.

Beispiele für Füllstoffe umfassen Glas; Calciumsulfat; Bariumsulfat; einfache und komplexe Silikate umfassend Natrium, Kalium, Calcium, Aluminium, Magnesium, Eisen und/oder Zirkonium; einfache und komplexe Aluminate umfassend Calcium, Magnesium und/oder Zirkonium; einfache und komplexe Titanate umfassend Calcium, Aluminium, Magnesium, Barium und/oder Zirkonium; einfache und komplexe Zirkonate umfassend Calcium, Aluminium und/oder Magnesium; Zirkoniumdioxid; Titandioxid; Aluminiumoxid; Siliziumdioxid, insbesondere in Form von Kieselsäure und Quarz; Siliziumcarbid; Aluminiumnitrid; Bornitrid und Siliziumnitrid. Hierin wird zwischen einfachen und komplexen Silikaten, Aluminaten, Titanaten und Zirkonaten unterschieden. Bei den komplexen Vertretern handelt es sich nicht etwa um Komplexverbindungen, vielmehr sind damit Silikate, Aluminate, Titanate und Zirkonate gemeint mit mehr als einer Art von Kationen, wie beispielsweise Natriumaluminiumsilikat, Calciumaluminiumsilikat, Bleizirkontitanat usw. Die Anwesenheit solcher Füllstoffe kann sich günstig auf die Wärmeleitfähigkeit und/oder das Wärmeausdehnungsverhalten der hydraulisch gehärteten anorganischen Zementzusammensetzung auswirken.

Beispiele für Fasern umfassen Glasfasern, Basaltfasern, Borfasern und keramische Fasern, beispielsweise Siliziumkarbidfasern und Aluminiumoxidfasern, Steinwollfasern, Wollastonitfasern und Aramidfasern. Die Anwesenheit von Fasern kann sich günstig auf die Zugspannungsfestigkeit und Temperaturwechselfestigkeit der hydraulisch gehärteten anorganischen Zementzusammensetzung auswirken.

Die Erfindung betrifft auch ein Verfahren zur Herstellung eines erfindungsgemäßen Elektronikobjektes mit einer mindestens eine wesentliche äußere Sichtfläche aufweisenden Umhüllung aus einer hydraulisch gehärteten anorganischen Zementzusammensetzung, wobei die jeweilige wesentliche äußere Sichtfläche der Umhüllung an ihrer Oberfläche und/oder innerhalb ihres unmittelbaren Untergrundes unterteilt ist. Das Herstellungsverfahren umfasst mindestens eine von zwei Verfahrensvarianten (A) und (B), d.h. die beiden Verfahrensvarianten (A) und (B) können auch miteinander kombiniert werden.

Verfahrensvariante (A) umfasst die Schritte (A1) bis (A3):
(A1a) Bereitstellen eines zu umhüllenden Elektronikobjektes,
(A1b) Bereitstellen einer wässrigen hydraulisch härtbaren anorganischen Zementzubereitung,
(A1c) Bereitstellen mindestens eines Unterteilungselementes,
(A2) Anordnen des oder der Unterteilungselemente und Applizieren der wässrigen hydraulisch härtbaren anorganischen Zementzubereitung unter Ausbildung einer Umhüllung des Elektronikobjektes, und
(A3) hydraulisches Härten und Trocknen der applizierten wässrigen hydraulisch härtbaren anorganischen Zementzubereitung.

Verfahrensvariante (B) umfasst die Schritte (B1) bis (B4):
(B1a) Bereitstellen eines zu umhüllenden Elektronikobjektes,
(B1b) Bereitstellen einer wässrigen hydraulisch härtbaren anorganischen Zementzubereitung,
(B2) Applizieren der wässrigen hydraulisch härtbaren anorganischen Zementzubereitung unter Ausbildung einer Umhüllung des Elektronikobjektes,
(B3) Unterteilen der mindestens einen wesentlichen äußeren Sichtfläche der Umhüllung, und
(B4) hydraulisches Härten und Trocknen der applizierten wässrigen hydraulisch härtbaren anorganischen Zementzubereitung.

Angesichts des Vorerwähnten bedarf weder der die Teilschritte (A1a) bis (A1c) umfassende Schritt (A1) der Variante (A) des erfindungsgemäßen Verfahrens noch der die Teilschritte (B1a) und (B1b) umfassende Schritt (B1) der Variante (B) des erfindungsgemäßen Verfahrens weiterer Erläuterungen für den Fachmann.

In Schritt (A2) des erfindungsgemäßen Verfahrens wird die wässrige hydraulisch härtbare anorganische Zementzubereitung appliziert. Das Applizieren der wässrigen hydraulisch härtbaren anorganischen Zementzubereitung kann vor oder nach dem Anordnen des oder der Unterteilungselemente erfolgen. Beispiele für dem Fachmann an sich bekannte Applikationsmethoden umfassen Spritzguss (englisch: transfer molding) und Vergussmethoden wie beispielsweise Schwerkraft-, vakuum- oder druckunterstützten Verguss (englisch: compression molding).

Bei der Herstellung eines erfindungsgemäßen umhüllten Elektronikobjektes in rahmenloser Ausführung ist es zweckmäßig, das zu umhüllende Elektronikobjekt mit einem temporären Rahmen oder mit einer Form oder mehreren Teilformen zu umschließen und dann mit der wässrigen hydraulisch härtbaren anorganischen Zementzubereitung zu füllen. Notwendige nach außen führende elektrische Kontaktierungen sowie eventuell vorhandene wärmeableitfähigen Anbindungen werden selbstverständlich nicht mitumhüllt. Nach Beendigung von Schritt (A3) kann das umhüllte Elektronikobjekt vom temporären Rahmen befreit oder nach Öffnen der Form oder der Teilformen entnommen werden. Der temporäre Rahmen kann dabei wie bereits erwähnt ein Unterteilungselement mitumfassen oder als solches ausgebildet sein.

Bei der Herstellung eines erfindungsgemäßen umhüllten Elektronikobjektes in einer Ausführung mit Rahmen wird die Applikation und auch der anschließende Schritt (A3) innerhalb eines für Elektronikobjekte üblichen nichttemporären Rahmens beispielsweise aus Kunststoff oder Kunstharz durchgeführt.

In Schritt (A2) wird nicht nur die wässrige hydraulisch härtbare anorganische Zementzubereitung unter Ausbildung einer Umhüllung appliziert, sondern es werden auch das oder die Unterteilungselemente angeordnet. Das Anordnen des oder der Unterteilungselemente kann vor oder nach dem Applizieren der wässrigen hydraulisch härtbaren anorganischen Zementzubereitung erfolgen; dies gilt insbesondere für den Fall der Herstellung eines erfindungsgemäßen umhüllten Elektronikobjekts in Rahmenbauweise. Im Falle der Herstellung eines erfindungsgemäßen umhüllten rahmenlosen Elektronikobjekts findet das Anordnen des oder der Unterteilungselemente bevorzugt vor dem Applizieren der wässrigen hydraulisch härtbaren anorganischen Zementzubereitung statt.

Das mindestens eine Unterteilungselement wird so angeordnet, dass es (i') in die mindestens eine wesentliche äußere Sichtfläche der späteren, fertigen Umhüllung - d.h. der nach Beendigung von Schritt (A3) erhaltenen Umhüllung - mit einer geringen Eindringtiefe von beispielsweise ≤ 5 mm, bevorzugt im Bereich von 0,2 bis 5 mm, insbesondere im Bereich von 0,2 bis 2 mm eindringt, und/oder (ii') dass es sich für einen Betrachter nicht sichtbar, beispielsweise in einer geringen Tiefe von ≤ 8 mm, bevorzugt im Bereich von 0,2 bis 8 mm, insbesondere im Bereich von 0,2 bis 2 mm, innerhalb des unmittelbaren Untergrundes der mindestens einen wesentlichen äußeren Sichtfläche der späteren, fertigen Umhüllung befindet. Das Anordnen des mindestens einen Unterteilungselements gemäß der Vorgehensweise (i') kann somit zu einer Verwirklichung der vorerwähnten Ausführungsform (i) eines erfindungsgemäßen umhüllten Elektronikobjekts führen; dementsprechend kann das Anordnen mindestens eines Unterteilungselements gemäß der Vorgehensweise (ii') zu einer Verwirklichung der vorerwähnten Ausführungsform (ii) eines erfindungsgemäßen umhüllten Elektronikobjekts führen.

Das jeweilige Unterteilungselement kann in Form und Größe respektive dem Format der jeweiligen wesentlichen äußeren Sichtfläche der späteren, fertigen Umhüllung zweckmäßig angepasst sein oder entsprechen, beispielsweise 50 bis 100 % des jeweiligen Formats entsprechen, es ist jedoch im Allgemeinen nicht größer als die jeweilige wesentliche äußere Sichtfläche der Umhüllung.

In Schritt (A3) des erfindungsgemäßen Verfahrens wird die in Schritt (A2) applizierte wässrige hydraulisch härtbare anorganische Zementzubereitung hydraulisch gehärtet und getrocknet.

Das hydraulische Härten (das Abbinden) kann bei Umgebungsbedingungen, beispielsweise bei einer Umgebungstemperatur im Bereich von 20 bis 25 °C stattfinden und dabei beispielsweise eine Dauer von 1 Minute bis 6 Stunden benötigen. Soll die Abbindedauer verkürzt werden, kann bei erhöhter Temperatur gearbeitet werden, beispielsweise kann das Abbinden bei 30 bis unter 100 °C Objekttemperatur stattfinden und es ist dann schon beispielsweise innerhalb weniger Sekunden bis 1 Stunde beendet. Das der Entwässerung dienende Trocknen schließt sich ans Abbinden an und benötigt beispielsweise 0,5 bis 6 Stunden bei 80 bis 300 °C Objekttemperatur, wobei es zweckmäßig sein kann, mehrere Temperaturstufen zu durchlaufen. Das Trocknen kann vakuumunterstützt erfolgen. Das Trocknen kann in und/oder außerhalb eines temporären Rahmens, von Formen oder Teilformen stattfinden.

Das erfindungsgemäße Verfahren kann mit Beendigung des Schrittes (A3) enden und als unmittelbares Verfahrenserzeugnis wird dann ein erfindungsgemäßes Elektronikobjekt mit einer Umhüllung aus einer hydraulisch gehärteten anorganischen Zementzusammensetzung entsprechend einer Verwirklichung einer der vorerwähnten Ausführungsformen (i2) oder (ii) erhalten.

Falls gewünscht, kann man ein Unterteilungselement in einem Schritt (A4) während des oder bevorzugt im Anschluss an das hydraulische Härten oder nach Beendigung von Schritt (A3), also im Anschluss an das Trocknen des Schrittes (A3), entfernen. Hierbei erhält man als unmittelbares Verfahrenserzeugnis ein erfindungsgemäßes Elektronikobjekt mit einer Umhüllung aus einer hydraulisch gehärteten anorganischen Zementzusammensetzung entsprechend einer Verwirklichung der Ausführungsform (i1). Im Hinblick auf das Entfernen eines nur temporär angeordneten Unterteilungselements kann es zweckmäßig sein, wenn das betreffende Unterteilungselement aus einem nicht oder nur wenig anhaftfähigen Material wie beispielsweise Polytetrafluorethylen besteht.

In Schritt (B2) des erfindungsgemäßen Verfahrens wird die wässrige hydraulisch härtbare anorganische Zementzubereitung appliziert unter Ausbildung einer Umhüllung des Elektronikobjektes. Beispiele für dem Fachmann an sich bekannte Applikationsmethoden sind dieselben wie bei Schritt (A2) erwähnt.

Bei der Herstellung eines erfindungsgemäßen umhüllten Elektronikobjektes in rahmenloser Ausführung, insbesondere einer entsprechenden erfindungsgemäßen umhüllten elektronischen Baugruppe, ist es zweckmäßig, das zu umhüllende Elektronikobjekt mit einem temporären Rahmen oder mit einer Form oder mehreren Teilformen zu umschließen und dann mit der wässrigen hydraulisch härtbaren anorganischen Zementzubereitung zu füllen. Notwendige nach außen führende elektrische Kontaktierungen sowie eventuell vorhandene wärmeableitfähige Anbindungen werden selbstverständlich nicht mitumhüllt. Nach Beendigung von Schritt (B4) kann das umhüllte Elektronikobjekt respektive die umhüllte elektronische Baugruppe vom temporären Rahmen befreit oder nach Öffnen der Form oder der Teilformen entnommen werden.

Bei der Herstellung eines erfindungsgemäßen umhüllten Elektronikobjektes in einer Ausführung mit Rahmen, insbesondere einer entsprechenden erfindungsgemäßen umhüllten elektronischen Baugruppe, wird die Applikation gemäß Schritt (B2) und auch der finale Schritt (B4) innerhalb eines für Elektronikobjekte respektive eines für elektronische Baugruppen üblichen nichttemporären Rahmens beispielsweise aus Kunststoff oder Kunstharz durchgeführt.

In Schritt (B3) des erfindungsgemäßen Verfahrens wird die mindestens eine wesentliche äußere Sichtfläche der Umhüllung, genauer gesagt die mindestens eine wesentliche äußere Sichtfläche der späteren, fertigen Umhüllung, unterteilt, beispielsweise durch Einbringen vorerwähnter Vertiefungen oder Einkerbungen in die in Schritt (B2) applizierte wässrige hydraulisch härtbare anorganische Zementzubereitung. Als Werkzeug kann ein entsprechend strukturierter Stempel verwendet werden oder ein anderes zur Einbringung einer oder mehrerer Vertiefungen geeignetes Werkzeug, beispielsweise ähnlich einem Messer oder einem Rechen. Der Fachmann wird den Zeitpunkt zum Einbringen der Vertiefungen in Kenntnis des Verarbeitungszeitraumes der in Schritt (B2) applizierten wässrigen hydraulisch härtbaren anorganischen Zementzubereitung entsprechend wählen, d.h. wenn die hydraulische Härtung schon hinreichend fortgeschritten, das Material jedoch noch weich genug ist zur Einbringung bleibender Vertiefungen, mit anderen Worten, wenn das im Zustand der hydraulischen Härtung befindliche Material nicht mehr eigenständig ohne äußere Einwirkung zusammenfließt.

In Schritt (B4) des erfindungsgemäßen Verfahrens wird die in Schritt (B2) applizierte und gemäß Schritt (B3) behandelte wässrige hydraulisch härtbare anorganische Zementzubereitung hydraulisch gehärtet und getrocknet, genauer gesagt, die hydraulische Härtung zu Ende geführt (hydraulisch ausgehärtet) und getrocknet.

Bezüglich des hydraulischen Härtens und Trocknens gilt dasselbe wie bei Schritt (A3) beschrieben.

Nach Beendigung von Schritt (B4) erhält man als unmittelbares Verfahrenserzeugnis ein erfindungsgemäßes Elektronikobjekt mit einer Umhüllung aus einer hydraulisch gehärteten anorganischen Zementzusammensetzung entsprechend einer Verwirklichung der Ausführungsform (i1).

### Beispiele

Erfindungsgemäßes Beispiel 1: 7 Gewichtsanteile Magnesiumoxidpulver, 2 Gewichtsanteile Magnesiumdihydrogenphosphatpulver, 4 Gewichtsanteile 2-Imidazolidinon, 6 Gewichtsanteile Glasfasern mit einer Faserlänge von 50 µm und einem Durchmesser von 15 µm, 66 Gewichtsanteile Zirkoniumsilikat mit einer maximalen Teilchengröße von 100 µm und 15 Gewichtsanteile Wasser wurden zu einer wässrigen Zementzubereitung vermischt.

Ein eine Halbbrücke auf einem DCB-Substrat aufweisendes Rahmenmodul des Formats 6 cm x 12 cm mit Kupferbodenplatte wurde mit der wässrigen Zementzubereitung im Vakuum vergossen und entgast. Anschließend wurde auf die frische Zementleimoberfläche ein Streifen einer medizinischen Gips-Bandage aus einem Baumwollgewebe mit einer rechteckigen Fläche von 5 cm x 8 cm mittig aufgelegt. Nach einem sechsstündigen hydraulischen Aushärten bei 20 °C wurde ein Temperaturprofil von aufeinanderfolgenden jeweils einstündigen Isothermen bei 90 °C und bei 160 °C durchlaufen und danach abkühlen gelassen. Die Aufheiz- und Abkühlraten betrugen jeweils 1 K/min. Lediglich in dem Bereich außerhalb der sichtbaren Gips-Baumwoll-Einlage waren Haarrisse zu finden.

Vergleichsbeispiel 2: Es wurde wie in Beispiel 1 gearbeitet, jedoch ohne Verwendung des Gips-Bandage-Streifens. Wesentliche Bereiche der Zementoberfläche waren von ungleichmäßig tiefen Rissen durchzogen.

## Patentansprüche

1. Elektronikobjekt mit einer mindestens eine wesentliche äußere Sichtfläche aufweisenden Umhüllung aus einer hydraulisch gehärteten anorganischen Zementzusammensetzung, wobei die jeweilige wesentliche äußere Sichtfläche der Umhüllung an ihrer Oberfläche und/oder innerhalb ihres unmittelbaren Untergrundes unterteilt ist.

2. Elektronikobjekt nach Anspruch 1, wobei es sich bei dem Elektronikobjekt um eine elektronische Baugruppe handelt.

3. Elektronikobjekt nach Anspruch 1 oder 2, wobei die mindestens eine wesentliche äußere Sichtfläche der Umhüllung (i) visuell erkennbar in mindestens zwei Teilflächen unterteilt und/oder (ii) innerhalb ihres unmittelbaren Untergrundes in mindestens zwei Teilflächen unterteilt ist.

4. Elektronikobjekt nach Anspruch 3, wobei die Unterteilung bei der Ausführungsform (i) in einer Variante (i1) als geringe Vertiefung verwirklicht ist oder in einer Variante (i2) dergestalt verwirklicht ist, dass mindestens ein Unterteilungselement visuell erkennbar vorhanden ist, welches in die jeweilige wesentliche äußere Sichtfläche der Umhüllung mit einer geringen Eindringtiefe eindringt.

5. Elektronikobjekt nach Anspruch 3, wobei die Unterteilung bei der Ausführungsform (ii) verwirklicht ist, indem sich mindestens ein Unterteilungselement für einen Betrachter nicht sichtbar innerhalb des unmittelbaren Untergrundes der jeweiligen wesentlichen äußeren Sichtfläche der Umhüllung befindet.

6. Elektronikobjekt nach Anspruch 4 oder 5, wobei das mindestens eine Unterteilungselement ein Öffnungen aufweisendes Flächengebilde ist.

7. Elektronikobjekt nach Anspruch 6, wobei das Öffnungen aufweisende Flächengebilde ausgewählt ist aus der Gruppe bestehend aus Gittern, Lochplatten, Sieben, Geweben und Netzen.

8. Elektronikobjekt nach Anspruch 6 oder 7, wobei die Öffnungen im Bereich von 7850 µm² bis 4 cm² groß sind.

9. Elektronikobjekt nach einem der Ansprüche 6 bis 8, wobei das Öffnungen aufweisende Flächengebilde aus einem oder mehreren verschiedenen Materialien besteht, welche ausgewählt sind unter gegebenenfalls faserverstärktem Kunststoff, Textilfaser, Baumwolle, Glasfaser und Steinwolle.

10. Elektronikobjekt nach einem der vorhergehenden Ansprüche, wobei die hydraulisch gehärtete anorganische Zementzusammensetzung aus einem hydraulisch gehärteten anorganischen Zement besteht oder neben dem hydraulisch gehärteten anorganischen Zement einen oder mehrere weitere Bestandteile umfasst, und wobei die hydraulisch gehärtete anorganische Zementzusammensetzung gebildet wird durch Vermischen von hydraulisch härtbarem anorganischem Zement plus gegebenenfalls dem mindestens einen weiteren Bestandteil mit Wasser zu einer wässrigen hydraulisch härtbaren anorganischen Zementzubereitung, Applikation derselben, gefolgt von deren hydraulischer Härtung und Trocknung.

11. Elektronikobjekt nach Anspruch 10, wobei der hydraulisch härtbare anorganische Zement ein schüttfähiges Pulver ist.

12. Elektronikobjekt nach Anspruch 10 oder 11, wobei der hydraulisch härtbare anorganische Zement ausgewählt ist aus der Gruppe bestehend aus Portlandzement, Tonerdezement, Magnesiumoxidzement und Phosphatzement.

13. Verfahren zur Herstellung eines Elektronikobjektes nach einem der vorhergehenden Ansprüche umfassend mindestens eine von zwei Verfahrensvarianten (A) und (B),
wobei Verfahrensvariante (A) die Schritte (A1) bis (A3) umfasst:
(A1a) Bereitstellen eines zu umhüllenden Elektronikobjektes,
(A1b) Bereitstellen einer wässrigen hydraulisch härtbaren anorganischen Zementzubereitung,
(A1c) Bereitstellen mindestens eines Unterteilungselementes,
(A2) Anordnen des oder der Unterteilungselemente und Applizieren der wässrigen hydraulisch härtbaren anorganischen Zementzubereitung unter Ausbildung einer Umhüllung des Elektronikobjektes, und
(A3) hydraulisches Härten und Trocknen der applizierten wässrigen hydraulisch härtbaren anorganischen Zementzubereitung, und
wobei Verfahrensvariante (B) die Schritte (B1) bis (B4) umfasst:
(B1a) Bereitstellen eines zu umhüllenden Elektronikobjektes,
(B1b) Bereitstellen einer wässrigen hydraulisch härtbaren anorganischen Zementzubereitung,
(B2) Applizieren der wässrigen hydraulisch härtbaren anorganischen Zementzubereitung unter Ausbildung einer Umhüllung des Elektronikobjektes,
(B3) Unterteilen der mindestens einen wesentlichen äußeren Sichtfläche der Umhüllung, und
(B4) hydraulisches Härten und Trocknen der applizierten wässrigen hydraulisch härtbaren anorganischen Zementzubereitung.

14. Verfahren nach Anspruch 13, wobei man ein Unterteilungselement in einem Schritt (A4) während des oder im Anschluss an das hydraulische Härten oder nach Beendigung von Schritt (A3) entfernt.

15. Verfahren nach Anspruch 13, wobei das Unterteilen gemäß Schritt (B3) durch Einbringen von Vertiefungen in die in Schritt (B2) applizierte wässrige hydraulisch härtbare anorganische Zementzubereitung erfolgt.
